# EUROPÄISCHE PATENTSCHRIFT

(11) **EP 1 181 691 B1**
(45) Veröffentlichungstag und Bekanntmachung des Hinweises auf die Patenterteilung: **24.08.2005**
(21) Anmeldenummer: 01921181.2
(22) Anmeldetag: 13.03.2001
(51) Int. Cl.: G11C 7/06, G11C 11/4091

(54) **SCHREIB-LESEVERSTÄRKER FÜR EINE DRAM-SPEICHERZELLE SOWIE DRAM-SPEICHER**
READ-WRITE AMPLIFIER FOR A DRAM MEMORY CELL AND DRAM MEMORY
AMPLIFICATEUR D'ECRITURE/DE LECTURE POUR UNE CELLULE MEMOIRE DRAM, ET MEMOIRE DRAM

(30) Priorität: 13.03.2000 DE 10012106
(43) Veröffentlichungstag der Anmeldung: 27.02.2002
(73) Patentinhaber: Infineon Technologies AG, 81669 München (DE)
(72) Erfinder: FREY, Alexander, 81735 München (DE)
(74) Vertreter: Dokter, Eric-Michael
(86) Internationale Anmeldenummer: PCT/DE2001/000940
(87) Internationale Veröffentlichungsnummer: WO 2001/069605

(56) Entgegenhaltungen:
- EP-A- 0 704 847
- US-A- 4 367 540
- US-A- 5 579 273
- PATENT ABSTRACTS OF JAPAN vol. 012, no. 245 (P-729), 12. Juli 1988 (1988-07-12) -& JP 63 037891 A (MITSUBISHI ELECTRIC CORP), 18. Februar 1988 (1988-02-18)

## Beschreibung

Die vorliegende Erfindung betrifft zunächst einen Schreib-Leseverstärker für eine DRAM-Speicherzelle gemäß dem Oberbegriff von Patentanspruch 1. Weiterhin betrifft die Erfindung einen DRAM-Speicher gemäß dem Oberbegriff von Patentanspruch 10. Schließlich betrifft die Erfindung noch ein Verfahren zum Bewerten von DRAM-Speicherzellen eines DRAM-Speichers.

DRAM-Speicherzellen (Dynamic-Random-Access-Memory-Speicherzellen) und -Speicher stellen einen wichtigen Speichertyp zum Speichern digitaler Informationen dar. Ein DRAM ist ein Speicher, bei dem man nach Vorgabe einer Adresse Daten abspeichern und unter dieser Adresse wieder auslesen kann. In DRAM-Speicherzellen, beziehungsweise -Speichern, wird die Information nicht als Schaltzustand eines Schaltkreises, sondern als Ladungsmenge auf einer Kapazität gespeichert. Eine solche Speicherzelle kann somit mit nur einem Speicherkondensator und einem Auswahltransistor gebildet werden. Da jeder Kondensator Leckströme aufweist und auch über den Auswahltransistor Leckströme fließen, wird die Information in der DRAM-Speicherzelle kontinuierlich abgebaut. Der Informationsgehalt der Speicherzelle geht deshalb mit der Zeit verloren. Um dies zu vermeiden, werden die Inhalte der Speicherzellen periodisch ausgelesen, die Speicherinhalte bewertet und die Speicherzelle erneut beschrieben. Das bedeutet, daß die Ladungsinhalte der Speicherkondensatoren wieder aufgefrischt werden, was als "Refresh" bezeichnet wird.

DRAM-Speicherzellen sind üblicherweise zu Speicherzellenfeldern zusammengeschaltet, wobei ein DRAM-Speicher ein oder mehrere solcher Speicherzellenfelder aufweist. Jede Speicherzelle ist über wenigstens eine Wortleitung und eine Bitleitung mit der Zellperipherie verbunden, beziehungsweise verdrahtet, wobei die Wortleitung(en) und die Bitleitung über die Speicherzelle geführt und zumindest im wesentlichen senkrecht zueinander orientiert sind. Durch Aktivieren einer bestimmten Wortleitung lassen sich alle damit verbundenen Speicherzellen über ihre Bitleitungen auslesen, beschreiben oder bezüglich ihres Informationsgehalts auffrischen (refreshen).

In DRAM-Speicherzellen können digitale Informationen beispielsweise in Form von logisch "0" und "1" gespeichert sein. Jeder dieser logischen Informationen ist ein bestimmter Spannungswert zugeordnet. Beispielsweise kann der Spannungswert für logisch "0" null Volt betragen, während der Spannungswert für logisch "1" beispielsweise 2 Volt beträgt. Vor dem Auslesen der Speicherzellen werden alle Bitleitungen mit einer Referenzspannung beaufschlagt, beispielsweise einer Spannung von 1 Volt. Beim Auslesen der Speicherzelle wird sich der Spannungswert je nach Informationsgehalt der Speicherzelle entweder etwas vergrößern oder aber verkleinern. Diese Spannungsänderung wird mit einer in einer Referenz-Bitleitung vorherrschenden Referenzspannung verglichen. Die Referenz-Bitleitung ist dabei mit einer Speicherzelle verbunden, die gerade nicht bewertet wird. Ist der Spannungswert in der zu bewertenden Bitleitung höher als die Referenzspannung, war die Speicherzelle mit dem Informationsgehalt logisch "1" beschrieben. Bei kleineren Spannungswerten war die Speicherzelle mit der Information logisch "0" beschrieben. Das aus der zu bewertenden Bitleitung sowie der Referenz-Bitleitung ausgelesene Spannungssignal wird in einem Schreib-Leseverstarker aufbereitet und weiterverarbeitet, beispielsweise verstärkt.

Je nach Speicherarchitektur können die Bitleitungen (BL) der zu bewertenden Speicherzellen und die jeweiligen Referenz-Bitleitungen (BBL) in ein und demselben Speicherzellenfeld nebeneinander angeordnet sein und damit jeweils ein Bitleitungspaar bilden. In anderen Speicherarchitekturen befinden sich die Referenz-Bitleitungen jeweils in einem anderen Speicherzellenfeld.

Wie bereits erwähnt wurde, werden die logischen Informationen "0" und "1" bei einem DRAM-Speicher in Form von Ladung in Zellkapazitäten gespeichert. Diese Ladungen werden in einem ersten Abschnitt der Bewertung in ein kleines Spannungssignal umgewandelt. Die Schreib-Leseverstärkerschaltung eines DRAM-Speichers hat die Aufgabe, dieses Spannungssignal auf vollen Pegel zu verstärken. Das verstärkte Signal dient einerseits dem Zurückschreiben der in der Speicherzelle beim Auslesen zerstörten Information und andererseits der Weiterleitung der gelesenen Information zur DRAM-Peripherie. Die Schreib-Leseverstärkerschaltung muß die genannten Aufgaben mit hoher Bewertungssicherheit und -geschwindigkeit bei möglichst geringem Platzbedarf erledigen.

Herkömmliche Schreib-Leseverstärkerschaltungen bestehen in der Regel aus einer Anzahl von Komponenten zum Auswerten, Verstärken und Weiterleiten von aus den Bitleitungen und Referenz-Bitleitungen ausgelesenen Spannungssignalen.

Zu diesen Komponenten gehört beispielsweise wenigstens eine sogenannte N-Latch-Schaltung (NL) die zur Herstellung des Low-Pegels für den Spannungswert dient. Die N-Latch-Schaltung hat die Aufgabe, ein Spannungssignal auf diesen Low-Pegel zu verstärken. Unter Bezugnahme auf das weiter oben genannte Zahlenbeispiel könnte der Low-Pegel beispielsweise der "0"-Volt-Wert sein.

Weiterhin kann der Schreib-Leseverstärker wenigstens eine sogenannte P-Latch-Schaltung (PL) aufweisen, die zur Herstellung eines High-Pegels dient. Die P-Latch-Schaltung dient also zum Verstärken eines Spannungssignals auf diesen High-Pegel, der im Zusammenhang mit dem oben genannten Zahlenbeispiel beispielsweise dem "2"-Volt-Wert entspricht.

Bei einer weiteren Komponente für den Schreib-Leseverstärker handelt es sich beispielsweise um den sogenannten Equalizer (EQ), der zur Herstellung eines Referenzspannungswerts (Vorladepegel) auf den Bitleitungen dient.

Darüber hinaus kann der Schreib-Leseverstärker wenigstens einen sogenannten Bit-Switch (BS) aufweisen, der zum Verbinden eines - beispielsweise durch eine sogenannte Column-Adresse - ausgewählten Bitleitungspaars mit externen Datenleitungen verwendet wird.

Schließlich kann der Schreib-Leseverstärker einen oder mehrere Transistoren zum Umschalten zwischen verschiedenen Bitleitungen aufweisen. Bei solchen Transistoren handelt es sich beispielsweise um Auswahltransistoren (MUX) zum Multiplexen der Schreib-Leseverstärker zwischen verschiedenen Bitleitungspaaren.

Die einzelnen Komponenten des Schreib-Leseverstärkers werden im weiteren Verlauf der Beschreibung noch näher erläutert.

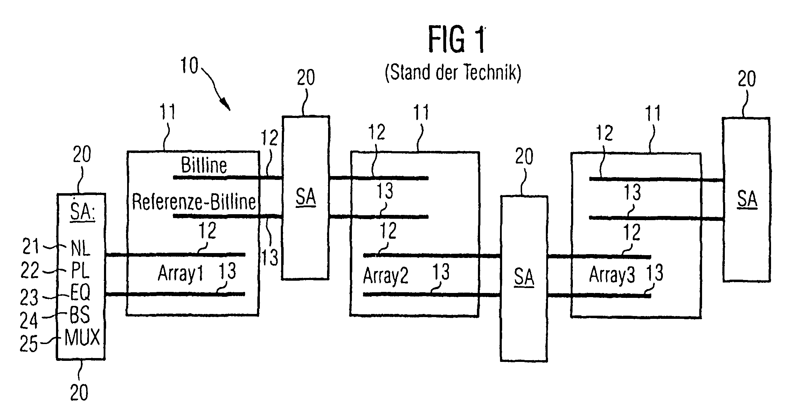

In Figur 1 ist schematisch ein aus dem Stand der Technik bekannter DRAM-Speicher dargestellt, in dem verschiedene Schreib-Leseverstärkerschaltungen (SA) für Bitleitungspaare benachbarter Speicherzellenfelder (Arrays) genutzt werden. Solche Schreib-Leseverstärkerschaltungen werden auch als "Shared Sense Amplifier" bezeichnet. Eine wie in Figur 1 dargestellte Anordnung der verschiedenen Schreib-Leseverstärkerschaltungen führt bereits zu einem günstigen Verhältnis der Flächenanteile von Speicherzellen und Schreib-Leseverstärkerschaltungen.

Je nach DRAM-Speichertyp kann die von dem oder den Schreib-Leseverstärkerschaltung(en) benötigte Fläche in bezug auf die Gesamtfläche des Speichers stark variieren. Üblicherweise bleibt die absolute Fläche einer Schreib-Leseverstärkerschaltung gleich, so daß sich je nach Speicherarchitektur die relative Größe der Schreib-Leseverstärkerschaltung im Gesamtspeicher ändert. Dabei kann die relative Größe der Schreib-Leseverstärkerschaltungen in einem DRAM-Speicher zwischen 5% und 30% der gesamten Speicherfläche betragen. Es besteht daher das Bedürfnis, die benötigte Fläche der Schreib-Leseverstärkerschaltungen bestmöglich zu minimieren.

Bei einem bekannten DRAM-Speicher kann mit Hilfe einer zweiten Metallebene in der integrierten Schaltung pro Speicherzellenfeld ein zusätzliches Bitleitungspaar mit jeder Schreib-Leseverstärkerschaltung bewertet werden. Diese Architektur halbiert damit die benötigte Anzahl von Schreib-Leseverstärkerschaltungen im Vergleich zu einer konventionellen, wie vorstehend beschriebenen Speicherarchitektur. Allerdings ist die Verwendung von zwei Metallebenen sehr kostenintensiv und damit nachteilig.

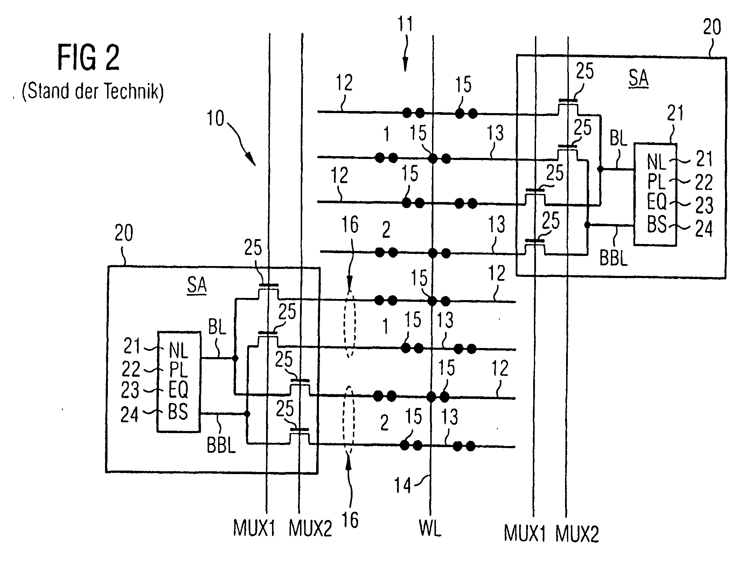

Ein anderer aus dem Stand der Technik bekannter Ansatz zur Einsparung von Schreib-Leseverstärkerfläche besteht in der mehrfachen Verwendung des gleichen Schreib-Leseverstärkers für verschiedene Bitleitungspaare durch Multiplexing. Ein solcher Ansatz ist beispielsweise in Figur 2 dargestellt und wird im Rahmen der Figurenbeschreibung näher erläutert. Dieses bekannte Prinzip beruht auf der mehrfachen Ausnutzung von Schreib-Leseverstärkerschaltungen für Bitleitungspaare im gleichen Speicherzellenfeld. Der Schreib-Leseverstärker (SA) wird durch Auswahltransistoren (MUX) mit jeweils komplementären Hälften von Bitleitungspaaren eines Zellenfeldes verbunden. Die angeschlossenen Bitleitungspaare können wie üblich bewertet werden. Auf den nicht angeschlossenen Bitleitungspaaren entwickelt sich ein unverstärktes Spannungssignal. Das Spannungssignal muß ungestört bestehen bleiben, bis die Schreib-Leseverstärkerschaltung an die entsprechenden Bitleitungen umgeschaltet werden. Die Signalverstärkung sowie das Zurückschreiben in die Speicherzellen kann nun erfolgen. Auf den im ersten Schritt bewerteten Bitleitungen müssen während dieser zweiten Phase die verstärkten Spannungspegel bestehen bleiben. Werden die oben genannten Voraussetzungen erfüllt, dann sind am Ende der zweiten Phase die ausgelesenen Informationen des gesamten Zellenfeldes zurückgeschrieben und die Wortleitung kann deaktiviert werden.

Ein Nachteil dieses Lösungsansatzes liegt jedoch in der zu erwartenden großen Störung des Spannungssignals auf den nicht angeschlossenen Bitleitungen durch kapazitive Überkopplung der Spannungsänderungen auf den benachbarten Bitleitungen, die an die Schreib-Leseverstärkerschaltungen angeschlossen sind. Diese Störungen können so groß werden, daß die dadurch bedingten Spannungsänderungen eine fehlerfreie Bewertung der Speicherzellen nicht mehr zulassen.

Ferner ist in US 4,916,667 ein DRAM-Speicher bekannt, bei dem eine Equalize-Komponente einem ersten Bitleitungs-Paar und die Bit-Switch-Komponente einem zweiten Bitleitungs-Paar zugeordnet sind, wobei das erste Bitleitungs-Paar und das zweite Bitleitungs-Paar zusammengeschaltet werden können.

US 5,757,692 beschreibt einen weiteren Halbleiterspeicher.

JP 63-37891 offenbart eine MOS-Speichervorrichtung mit einem geteilten Leseverstärker, der drei Latch-Schaltungen aufweist, woven zwei an den Ender von einem Bitleitungspaar liegen und einer in der Mitte des Bitleitungspaars liegt.

US 4,367,540 offenbart einen dynamischen Speicher mit einem Leseverstärker, dessen zwei Latch-Schaltungen an den Enden eines Bitleitungspaares liegen.

Ausgehend vom genannten Stand der Technik liegt der vorliegenden Erfindung die Aufgabe zu Grunde, einen Schreib-Leseverstärker, einen DRAM-Speicher sowie ein Verfahren zum Bewerten von DRAM-Speicherzellen eines DRAM-Speichers bereitzustellen, mit dem die genannten Nachteile vermieden werden. Insbesondere soll die Schreib-Leseverstärkerschaltung die ihr zugedachten Aufgaben mit hoher Bewertungssicherheit und -geschwindigkeit bei möglichst geringem Platzbedarf erledigen können.

Diese Aufgabe wird gelöst durch den Schreib-Leseverstärker für eine DRAM-Speicherzelle gemäß Patentanspruch 1, den DRAM-Speicher gemäß Patentanspruch 10 sowie das Verfahren zum Bewerten von DRAM-Speicherzellen eines DRAM-Speichers gemäß Patentanspruch 15. Weitere vorteilhafte Merkmale, Aspekte und Details der Erfindung ergeben sich aus den abhängigen Ansprüchen, der Beschreibung und den Zeichnungen. Vorteile und Merkmale, die in bezug auf den Schreib-Leseverstärker beschrieben sind, gelten ebenso für den DRAM-Speicher sowie das Verfahren. Vorteile und Merkmale, die in bezug auf den DRAM-Speicher beschrieben sind, gelten ebenso für den erfindungsgemäßen Schreib-Leseverstärker sowie das erfindungsgemäße Verfahren. Analoges gilt für das erfindungsgemäße Verfahren.

Gemäß dem ersten Aspekt der vorliegenden Erfindung wird ein Schreib-Leseverstärker für eine DRAM-Speicherzelle bereitgestellt, der zum Bewerten des Informationsgehalts wenigstens einer DRAM-Speicherzelle mit wenigstens einer Bitleitung und mit wenigstens einer Referenz-Bitleitung, die jeweils ein Bitleitungspaar bilden, verbunden oder verbindbar ist. Der Schreib-Leseverstärker weist eine Anzahl von Komponenten zum Auswerten, Verstärken und Weiterleiten von aus den Bitleitungen und Referenz-Bitleitungen ausgelesenen Spannungssignalen auf. Erfindungsgemäß ist dieser Schreib-Leseverstärker dadurch gekennzeichnet, daß er ein erstes Schreib-Leseverstärkerelement und ein dazu separates zweites Schreib-Leseverstärkerelement aufweist, und daß die einzelnen Verstärkerkomponenten auf die beiden Schreib-Leseverstärkerelemente aufgeteilt sind.

Dadurch wird eine flächenoptimierte DRAM-Schreib-Leseverstärkerschaltung geschaffen, die nur einen_geringen Platzbedarf aufweist, und mit der die Bewertung von DRAM-Speicherzellen, insbesondere von Speicherzellen eines einzigen Speicherzellenfeldes, mit großer Sicherheit und Geschwindigkeit bewertet werden können.

Durch den erfindungsgemäßen Schreib-Leseverstärker wird es möglich, die zum Stand der Technik geschilderten Probleme zu umgehen, indem die einzelnen Komponenten des Schreib-Leseverstärkers für mehrere Bitleitungspaare in einem Speicherzellenfeld verwendet werden können, und wobei eine gleichzeitige unmittelbare Verstärkung aller Signale ermöglicht wird.

Ein Grundgedanke der vorliegenden Erfindung besteht darin, daß die einzelnen Komponenten der Schreib-Leseverstärkerschaltung nunmehr auf zwei Schreib-Leseverstärkerelemente aufgeteilt werden. Diese beiden Schreib-Leseverstärkerelemente sind separat voneinander ausgeführt. Das erste Schreib-Leseverstärkerelement (SAINT) dient primär dem Rückschreiben vom Zellinformationen, während das zweite Schreib-Leseverstärkerelement (SAEX) außerdem die ausgelesene Information, beziehungsweise das ausgelesene Datum, in einen externen Bereich des DRAM-Speichers treiben kann und das Schreiben von Zellinformationen ermöglicht.

Da nunmehr mehrere Bitleitungen, beziehungsweise Bitleitungspaare, von ein und demselben Schreib-Leseverstärker, der lediglich auf zwei Verstärkerelemente aufgeteilt wurde, bewertet werden können, läßt sich der erforderliche Platzbedarf für die Schreib-Leseverstärkerschaltungen im gesamten DRAM-Speicher erheblich reduzieren.

Als Bewerten einer Speicherzelle wird im Lichte der vorliegenden Erfindung nicht nur das Auslesen von Informationen aus einer Speicherzelle verstanden, sondern auch das Weiterleiten der Information sowie das anschließende Zurückschreiben der Zellinformation bei Beendigung des Bewertungsvorgangs.

Zur Funktionsweise des erfindungsgemäßen Schreib-Leseverstärkers wird ebenfalls auf die Ausführungen zum erfindungsgemäßen Verfahren verwiesen.

Vorteilhaft können die Verstärkerkomponenten wenigstens eine N-Latch-Schaltung zum Verstärken eines Spannungssignals auf einen Low-Pegel und/oder wenigstens eine P-Latch-Schaltung zum Verstärken eines Spannungssignals auf einen High-Pegel und/oder wenigstens einen Equalizer zum Herstellen eines Referenzspannungswerts auf der/den Bitleitung(en) sowie der/den Referenz-Bitleitung(en) und/oder wenigstens einen Bit-Switch zum Verbinden wenigstens eines ausgewählten Bitleitungspaars mit wenigstens einer externen Datenleitung aufweisen.

Vorzugsweise kann im ersten Schreib-Leseverstärkerelement wenigstens eine N-Latch-Schaltung und wenigstens eine P-Latch-Schaltung vorgesehen sein.

Weiterhin kann das erste Schreib-Leseverstärkerelement über wenigstens einen Equalizer verfügen. Der Equalizer hat die Funktion, die nach dem Bewertungsvorgang auf Low-Pegel und/oder High-Pegel verstärkten Spannungssignale erneut auf den Referenzspannungswert einzustellen.

Im zweiten Schreib-Leseverstärkerelement kann vorteilhaft wenigstens eine N-Latch-Schaltung vorgesehen sein.

Weiterhin kann im zweiten Schreib-Leseverstärkerelement wenigstens ein Bit-Switch vorgesehen sein. Wenn nur das zweite Schreib-Leseverstärkerelement über ein Bit-Switch verfügt, kann jeweils nur die Hälfte der durch eine Wortleitung aktivierten Speicherzellen potentiell gelesen oder neu beschrieben werden. Der Bit-Switch hat dabei folgende Grundfunktion. Wenn eine bestimmte Speicherzelle ausgelesen werden soll, wird die ganze Page, das heißt die Menge aller Speicherzellen, die mit einer Wortleitung verbunden sind, angesteuert, in der sich diese Speicherzelle befindet. Das bedeutet, daß die Informationen der gesamten Page ausgelesen werden. Über eine Aktivierung des Bit-Switch kann/können nunmehr aus der gesamten Menge der ausgelesenen Speicherzellen diejenige(n) Speicherzelle(n) ausgewählt werden, deren Informationsgehalt wirklich von Interesse ist.

In weiterer Ausgestaltung kann das zweite Schreib-Leseverstärkerelement mit wenigstens einer externen Datenleitung verbunden oder verbindbar sein. Diese externen Datenleitungen führen von der bewerteten DRAM-Speicherzelle, beziehungsweise dem Speicherzellenfeld, hin zur DRAM-Speicherperipherie.

Vorteilhaft kann das zweite Schreib-Leseverstärkerelement mit wenigstens einem weiteren Schreib-Leseverstärker verbunden oder verbindbar sein. Dieser zusätzliche Schreib-Leseverstärker, auch "Secondary Sense Amplifier (SSA)" genannt, kann die aus dem dem DRAM-Speicher zugeordneten Schreib-Leseverstärker ausgelesenen und entsprechend verstärkten Spannungssignale weiter verstärken, so daß diese Spannungssignale auch außerhalb des DRAM-Speichers weiter verwertet werden können.

Das erste und/oder das zweite Schreib-Leseverstärkerelement kann/können ein oder mehrere Transistoren zum Umschalten zwischen verschiedenen Bitleitungen, beziehungsweise Referenz-Bitleitungen, aufweisen. Über diese Transistoren, die beispielsweise auch Auswahltransistoren oder Multiplextransistoren genannt werden, wird bestimmt, welches Bitleitungspaar aktiv mit dem ersten und/oder zweiten Schreib-Leseverstärkerelement verbunden wird.

Gemäß einem zweiten Aspekt der vorliegenden Erfindung wird ein DRAM-Speicher bereitgestellt, mit einer Anzahl von DRAM-Speicherzellen, die jeweils ein oder mehrere Speicherzellenfelder bilden, wobei jede Speicherzelle mit einer Bitleitung verbunden ist und die Bitleitungen weiterhin mit wenigstens einem Schreib-Leseverstärker verbunden sind. Erfindungsgemäß ist vorgesehen, daß der wenigstens eine Schreib-Leseverstärker als ein wie vorstehend beschriebener erfindungsgemäßer Schreib-Leseverstärker ausgebildet ist.

Ein auf diese Weise ausgebildeter erfindungsgemäßer DRAM-Speicher ermöglicht, daß die einzelnen Speicherzellen mit hoher Bewertungssicherheit und -geschwindigkeit bei einem sehr geringen Platzbedarf der Schreib-Leseverstärkerschaltungen und damit des DRAM-Speichers bewertet werden können. Zur Funktionsweise des erfindungsgemäßen DRAM-Speichers wird ebenfalls auf die Ausführungen zum erfindungsgemäßen Verfahren verwiesen.

Vorteilhaft kann wenigstens eine Wortleitung vorgesehen sein, die über das oder die Speicherzellenfeld(er) des DRAM-Speichers hinüber geführt ist und die zum Aktivieren der DRAM-Speicherzellen mit einer oder mehreren Speicherzelle(n) verbunden ist. Die wenigstens eine physikalische Wortleitung kann dabei durch die Auswahltransistoren in zwei logische Wortleitungen aufgeteilt werden. Die Zellsignale einer Wortleitungshälfte werden von dem ersten Schreib-Leseverstärkerelement verstärkt, während die Zellsignale der anderen Wortleitungshälfte von dem zweiten Schreib-Leseverstärkerelement verstärkt werden.

Vorzugsweise sind mehrere Bitleitungen eines Speicherzellenfeldes mit dem Schreib-Leseverstärker verbunden.

Jeweils eine Bitleitung einer zu bewertenden DRAM-Speicherzelle und eine Referenz-Bitleitung einer nicht zu bewertenden DRAM-Speicherzelle können ein Bitleitungspaar bilden, wobei jedes Bitleitungspaar sowohl mit dem ersten als auch mit dem zweiten Schreib-Leseverstärkerelement verbunden ist.

Dabei kann die Verbindung einer Bitleitung und/oder Referenz-Bitleitung mit dem Schreib-Leseverstärker vorzugsweise über einen oder mehrere Transistoren aktiviert werden oder aktivierbar sein.

Gemäß einem dritten Aspekt der vorliegenden Erfindung wird ein Verfahren zum Bewerten von DRAM-Speicherzellen eines DRAM-Speichers, insbesondere eines wie vorstehend beschriebenen erfindungsgemäßen DRAM-Speichers und insbesondere unter Verwendung eines wie vorstehend beschriebenen erfindungsgemäßen Schreib-Leseverstärkers bereitgestellt, das folgende Schritte aufweist.

Zunächst wird/werden ein oder mehrere zu bewertende Speicherzelle(n) über wenigstens eine Wortleitung aktiviert. Wenn mehrere Speicherzellen bewertet werden sollen, befinden sich diese vorzugsweise innerhalb eines einzigen Speicherzellenfeldes. Durch die Aktivierung der Wortleitung können die mit ihr verbundenen Speicherzellen ausgelesen werden.

Anschließend wird die Verbindung wenigstens eines aus einer Bitleitung der zu bewertenden Speicherzelle und eines aus einer Referenz-Bitleitung einer nicht zu bewertenden Speicherzelle gebildeten ersten Bitleitungspaars mit einem ersten Schreib-Leseverstärkerelement aktiviert und gleichzeitig die Verbindung wenigstens eines, zum ersten Bitleitungspaar benachbarten, zweiten Bitleitungspaars mit einem zweiten Schreib-Leseverstärkerelement aktiviert, wobei beide Bitleitungspaare jeweils mit dem ersten und zweiten Schreib-Leseverstärkerelement verbunden sind.

Wenn der Schreib-Leseverstärker beispielsweise mit zwei Bitleitungspaaren verbunden ist, das heißt jedes der beiden Schreib-Leseverstärkerelemente ist jeweils mit beiden Bitleitungspaaren verbunden, können die Transistoren zunächst so geschaltet werden, daß eines der beiden Bitleitungspaare aktiv an das erste Schreib-Leseverstärkerelement angekoppelt ist, während das andere Bitleitungspaar aktiv an das zweite Schreib-Leseverstärkerelement angekoppelt ist.

Danach werden die über das erste Bitleitungspaar ausgelesenen Spannungssignale über wenigstens eine im ersten Schreib-Leseverstärkerelement vorgesehen N-Latch-Schaltung sowie eine P-Latch-Schaltung verstärkt. Gleichzeitig werden die über das zweite Bitleitungspaar ausgelesenen Spannungssignale über wenigstens eine im zweiten Schreib-Leseverstärkerelement vorgesehene N-Latch-Schaltung verstärkt. Dies geschieht beispielsweise wie folgt.

Zu Beginn der Bewertung werden vorzugsweise alle Bitleitungen mit einer Referenzspannung beaufschlagt. Wenn die auszulesenden Zellen aktiviert werden, verändert sich durch die Aktivierung der auf der zu bewertenden Bitleitung anliegende Spannungswert. Beispielsweise steigt der Spannungswert bei einer in der Speicherzelle befindlichen Information von logisch "1" leicht an, während er bei einer in der Speicherzelle gespeicherten logischen Information "0" leicht absinkt. Bei der nicht aktivierten Referenz-Bitleitung bleibt der Spannungswert jedoch im wesentlichen konstant. Im Vergleich zwischen der Bitleitung (BL) und der Referenz-Bitleitung (BBL) kann man nun sehen, welche Information in der Speicherzelle gespeichert war, je nachdem, ob der ausgelesene Spannungswert oberhalb oder unterhalb vom Referenzspannungswert liegt.

Die Zellsignale der mit dem zweiten Schreib-Leseverstärkerelement verbundenen Speicherzellen, beziehungsweise die über die entsprechenden Bitleitungen ausgelesenen Spannungswerte werden zunächst nur über eine N-Latch-Schaltung verstärkt. Wenn in der zu bewertenden Speicherzelle eine Information logisch "0" gespeichert war, bedeutet dies, daß der bei Beginn der Bewertung auf der auszulesenden Bitleitung anliegende Spannungswert kleiner als der Referenzspannungswert auf der Referenz-Bitleitung ist. Durch die N-Latch-Schaltung werden die Spannungswerte derjenigen Bitleitungen auf den Low-Pegel verstärkt, die einen geringeren Spannungswert aufweist. In diesem Fall bedeutet dies, daß die Speicherzelle mit der Information logisch "0" auf den Low-Pegel herunterverstärkt wird. Das Spannungssignal der Referenz-Bitleitung bleibt zunächst im wesentlichen unverändert, beziehungsweise sinkt wesentlich weniger ab als das Spannungssignal der Bitleitung.

Wenn sich in der zu bewertenden Speicherzelle eine Information logisch "1" befunden hätte, hätte dies zu einer leichten Spannungserhöhung gegenüber dem Referenzspannungswert geführt. Durch die N-Latch-Schaltung wäre wiederum der niedrigere der beiden Spannungswerte auf Low-Pegel herunterverstärkt worden. In diesem Fall wäre dies der Spannungswert an der Referenz-Bitleitung gewesen. Aus den sich im wesentlichen nicht verändernden beziehungsweise wesentlich weniger absinkenden Spannungswert der zu bewertenden Bitleitung wäre dann zu entnehmen gewesen, daß der in der zu bewertenden Speicherzelle gespeicherte Informationsgehalt logisch "1" beträgt.

Auch durch Verwendung nur einer einzigen N-Latch-Schaltung im zweiten Schreib-Leseverstärkerelement kann während des ersten Verstarkungsschritts genau gesagt werden, was für eine Information in den Speicherzellen gespeichert war, beziehungsweise ist. Wenn der Spannungswert auf der zu bewertenden Bitleitung auf Low-Level runtergezogen wird, weiß man, daß die Information in der Speicherzelle logisch "0" war. Wenn jedoch der Spannungswert der Referenz-Bitleitung auf Low-Level runtergezogen wird, weiß man, daß die Information in der Speicherzelle logisch "1" war.

Gleichzeitig mit der Verstärkung im zweiten Schreib-Leseverstärkerelement werden auch die mit dem ersten Schreib-Leseverstärkerelement verbundenen Speicherzellen bewertet. Das erste Schreib-Leseverstärkerelement weist neben der N-Latch-Schaltung jedoch noch eine weitere P-Latch-Schaltung auf. Wie im Hinblick auf das zweite Schreib-Leseverstärkerelement vorstehend beschrieben wurde, werden die jeweils niedrigeren Spannungen in einem Bitleitungspaar zum Low-Pegel verstärkt. Die jeweils anderen Zellsignale, das heißt die höheren Spannungssignale, werden über die P-Latch-Schaltung auf den vollen High-Pegel verstärkt. Das bedeutet, wenn der Spannungswert auf der Bitleitung der zu bewertenden Speicherzelle auf Low-Pegel herunterverstärkt wurde, wird der auf der Referenz-Bitleitung anliegende Spannungswert auf den High-Pegel verstärkt.

Grundsätzlich werden zu beiden Pegeln verstärkte Spannungssignale benötigt, um die Speicherzellen anschließend zurückschreiben zu können. Dies bedeutet, daß auch die im zweiten Schreib-Leseverstärkerelement zunächst nicht auf High-Pegel verstärkten Spannungswerte noch in entsprechender Weise verstärkt werden müssen.

Nachdem die Spannungssignale in der vorstehenden Weise verstärkt wurden, werden die Daten der mit dem ersten Schreib-Leseverstärkerelement aktiv verbundenen zu bewertenden Speicherzelle(n) bewertet und anschließend zurückgeschrieben. Nach dem Zurückschreiben der Daten durch das erste Schreib-Leseverstärkerelement können die entsprechenden Bitleitungspaare durch die Auswahltransistoren abgeklemmt werden, so daß sie mit vollen Spannungspegeln floaten.

Danach wird die Verbindung zwischen den Bitleitungspaaren und dem ersten Schreib-Leseverstärkerelement derart umgeschaltet, daß die P-Latch-Schaltung des ersten Schreib-Leseverstärkerelements nunmehr an das zweite Schreib-Leseverstärkerelement umgeschaltet wird.

Die N-Latch-Schaltung des ersten Schreib-Leseverstärkerelements wird nun abgeschaltet, während die noch aktive P-Latch-Schaltung an das mit dem zweiten Schreib-Leseverstärkerelement verbundene Bitleitungspaar angekoppelt wird. Dadurch können die bisher nicht auf High-Pegel verstärkten Spannungen des Bitleitungspaars auf vollen Pegel verstärkt werden. Dabei wird die N-Latch-Schaltung des zweiten Schreib-Leseverstärkerelements ebenfalls aktiv gehalten.

Danach erfolgt ein Bewerten und Zurückschreiben der Daten der mit dem zweiten Schreib-Leseverstärkerelement aktiv verbundenen zu bewertenden Speicherzelle(n).

Anschließend können zum Beenden des Bewertungsverfahrens die zu bewertenden Speicherzellen deaktiviert werden.

Ein Zeitverlust entsteht durch die nacheinander stattfindende Verstärkung auf den High-Level der einzelnen Bitleitungspaare durch nur eine einzige P-Latch-Schaltung nicht, da die Zellinformationen über das zweite Schreib-Leseverstärkerelement bereits nach außen abgegeben werden können, bevor beide Pegel, das heißt der Low-Pegel und auch der High-Pegel, voll installiert sind.

Vor der Bewertung der Speicherzellen kann an allen Bitleitungen der in einem oder mehreren Speicherzellenfeldern vorgesehenen Speicherzellen eine einheitliche Referenzspannung angelegt werden. Das Erzeugen und die Funktion einer solchen Referenzspannung sind weiter oben eingehend erläutert worden.

Vorzugsweise kann nach dem Aktivieren eines im zweiten Schreib-Leseverstärkerelement vorgesehenen Bit-Switchs auf einer oder mehreren mit diesem verbundenen externen Datenleitung(en) eine Spannungsdifferenz erzeugt werden. Diese Spannungsdifferenz kann dann von einem weiteren, externen Schreib-Leseverstärker bewertet werden.

Vorteilhaft kann nach Beendigung des Bewertungsvorgangs an allen Bitleitungen der bewerteten Speicherzellen über einen Equalizer die einheitliche Referenzspannung angelegt werden.

Die Erfindung wird nun an Hand von Ausführungsbeispielen unter Bezugnahme auf die beiliegende Zeichnung näher erläutert. Es zeigen:
Figur 1 eine Schaltungsanordnung eines aus dem Stand der Technik bekannten DRAM-Speichers;
Figur 2 eine Schaltungsanordnung eines weiteren aus dem Stand der Technik bekannten DRAM-Speichers;
Figur 3 eine Schaltungsanordnung eines DRAM-Speichers gemäß der vorliegenden Erfindung;
Figur 4 die Signalabfolge der Schreib-Leseverstärkeransteuerung eines erfindungsgemäßen Schreib-Leseverstärkers;
Figuren 5a bis 5c Spannungsverläufe für das interne Auslesen und Zurückschreiben von unterschiedlichen Zellinformationen in durch eine aktive Wortleitung sowie zwei Bitleitungen verbundene Speicherzellen; und
Figuren 6a und 6b Spannungsverläufe für das externe Lesen und Schreiben von Zellinformationen einer mit einer Bitleitung verbundenen Speicherzelle.

In Figur 1 ist ein aus dem Stand der Technik bekannter DRAM-Speicher 10 dargestellt, der eine Anzahl von Speicherzellenfeldern 11 aufweist. Im vorliegenden Ausführungsbeispiel sind drei solcher Speicherzellenfelder 11 (Arrays 1 bis 3) dargestellt. Jedes Speicherzellenfeld 11 verfügt über eine Anzahl von DRAM-Speicherzellen. Jede DRAM-Speicherzelle ist über eine Bitleitung 12 mit einem Schreib-Leseverstärker (SA) 20 verbunden. Jeder der Schreib-Leseverstärker 20 ist weiterhin mit einer Referenz-Bitleitung 13 verbunden.

Wie aus Figur 1 zu ersehen ist, wird eine Schreib-Leseverstärkerschaltung 20 jeweils für Bitleitungspaare 12, 13 benachbarter Zellenfelder 11 verwendet, wodurch bereits ein günstiges Verhältnis der Flächenanteile von Speicherzellen und Schreib-Leseverstärkerschaltungen 20 erzielt wird.

Jede der Schreib-Leseverstärker 20 verfügt über eine Anzahl von Verstärkerkomponenten. Diese Verstärkerkomponenten sind zum Beispiel eine N-Latch-Schaltung (NL) 21 zum Verstärken eines Spannungssignals auf Low-Pegel, eine P-Latch-Schaltung (PL) 22 zum Verstärken eines Spannungssignals auf High-Pegel, ein Equalizer (EQ) 23 zum Herstellen eines Referenzspannungswerts auf der/den Bitleitung(en) 12 sowie der/den Referenz-Bitleitung(en) 13 sowie ein Bit-Switch (BS) 24 zum Verbinden wenigstens eines ausgewählten Bitleitungspaars 12, 13 mit wenigstens einer externen Datenleitung. Um zwischen verschiedenen Bitleitungen 12, beziehungsweise Referenz-Bitleitungen 13, umschalten zu können, sind weiterhin ein oder mehrere Auswahltransistoren (MUX) pro Schreib-Leseverstärker 20 vorgesehen.

In den DRAM-Speicherzellen können digitale Informationen beispielsweise in Form von logisch "0" und "1" gespeichert sein. Jeder dieser logischen Informationen ist ein bestimmter Spannungswert zugeordnet. Beispielsweise kann der Spannungswert für logisch "0" null Volt betragen, während der Spannungswert für logisch "1" beispielsweise 2 Volt beträgt. Vor dem Auslesen der Speicherzelle werden alle Bitleitungen 12 und Referenz-Bitleitungen 13 mit einer Referenzspannung beaufschlagt, beispielsweise einer Spannung von 1 Volt. Beim Auslesen der Speicherzelle wird sich der Spannungswert an der entsprechenden Bitleitung 12 je nach Informationsgehalt der Speicherzelle etwas vergrößern oder aber etwas verkleinern. Diese Spannungsänderung wird mit der in der Referenz-Bitleitung 13 weiterhin vorherrschenden unveränderten Referenzspannung verglichen. Ist der Spannungswert in der zu bewertenden Bitleitung 12 höher als in der Referenz-Bitleitung 13, war die Speicherzelle mit dem Informationsgehalt logisch "1" beschrieben. Bei kleineren Spannungswerten war die Speicherzelle mit der Information logisch "0" beschrieben. Die aus der zu bewertenden Bitleitung 12 sowie der Referenz-Bitleitung 13 ausgelesenen Spannungssignale werden von dem Schreib-Leseverstärker 20 aufbereitet und verstärkt.

Bei dem in Figur 2 dargestellten DRAM-Speicher 10 handelt es sich ebenfalls um eine aus dem Stand der Technik bekannte Speicherarchitektur. Der DRAM-Speicher 10 verfügt über ein oder mehrere Speicherzellenfeld(er) 11, in dem eine Anzahl von DRAM-Speicherelementen 15 vorgesehen sind. Zur besseren Übersicht ist in Figur 2 nur ein einziges Speicherzellenfeld 11 dargestellt. Die einzelnen Speicherzellen 15 sind durch große schwarze Punkte dargestellt. Um die einzelnen Speicherzellen 15 aktivieren zu können, ist eine Wortleitung 14 vorgesehen, die mit mehreren Speicherzellen 15 verbunden ist. Über eine Aktivierung der Wortleitung 14 werden alle mit dieser verbundenen Speicherzellen 15 aktiviert.

Weiterhin sind jeweils eine Anzahl von Bitleitungen 12 sowie Referenz-Bitleitungen 13 vorgesehen, wobei jeweils eine Bitleitung 12 und eine dazu benachbarte Referenz-Bitleitung 13 ein Bitleitungspaar 16 bildet. Die Zusammengehörigkeit einer Bitleitung 12 sowie einer Referenz-Bitleitung 13 als Bitleitungspaar 16 ist in Figur 1 durch einen die beiden Bitleitungen 12, 13 umgebenden Kreis symbolisiert.

Der DRAM-Speicher 10 gemäß Figur 2 weist zwei Schreib-Leseverstärker 20 auf, wobei jeweils ein Schreib-Leseverstärker 20 für verschiedene Bitleitungspaare 16 innerhalb des gleichen Speicherzellenfeldes 11 verwendet werden kann. Jeder Schreib-Leseverstärker 20 weist wiederum eine N-Latch-Schaltung 21, eine P-Latch-Schaltung 22, einen Equalizer 23 sowie ein Bit-Switch 24 auf.

Die Schreib-Leseverstärker 20 sind über Auswahltransistoren (MUX1, MUX2) 25 mit jeweils komplementären Hälften von Bitleitungspaaren 16 eines Speicherzellenfeldes 11 verbunden. Die angeschlossenen Bitleitungspaare 16 können wie üblich bewertet werden. Auf den nicht angeschlossenen Bitleitungspaaren 16 entwickelt sich das unverstärkte Spannungssignal. Das Spannungssignal muß ungestört bestehen bleiben, bis die Schreib-Leseverstärker 20 über entsprechende Ansteuerung der Transistoren 25 an die entsprechenden Bitleitungen 12,13 umgeschaltet werden. Die Signalverstärkung sowie das Zurückschreiben in die Speicherzellen 15 kann nun erfolgen. Auf den im ersten Schritt bewerteten Bitleitungen 12 müssen während dieser zweiten Phase die verstärkten Spannungspegel bestehen bleiben.

Wie im Rahmen der Beschreibungseinleitung erläutert wurde, weist eine derartige Ausgestaltung des DRAM-Speichers 10 jedoch erhebliche Nachteile auf, da die Spannungssignale auf den nicht abgeschlossenen Bitleitungen 12, 13 durch kapazitive Überkopplung der Spannungsänderungen auf den benachbarten Bitleitungen 12, 13, die an die Schreib-Leseverstärker 20 angeschlossen sind, gestört werden.

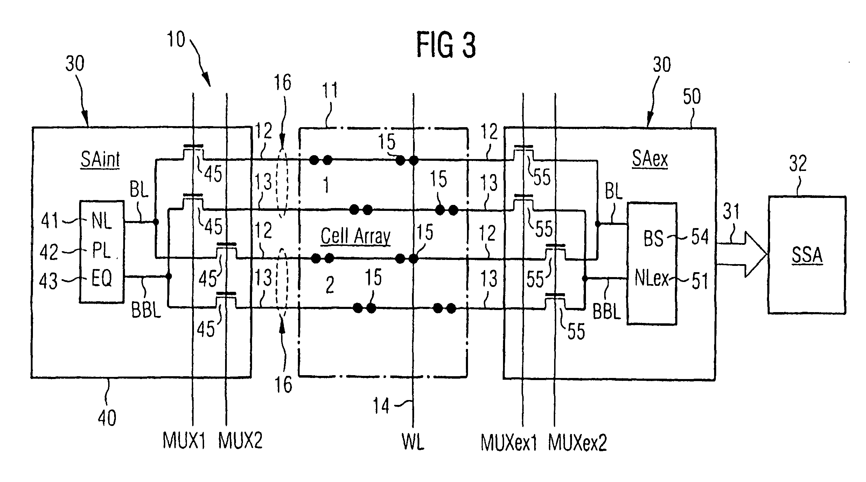

Eine erfindungsgemaße Schreib-Leseverstärkerschaltung 20, mit der DRAM-Speicherzellen mit hoher Bewertungssicherheit und -geschwindigkeit bewertet werden können, und die nur einen geringen Platzbedarf aufweist, ist im Zusammenhang mit Figur 3 dargestellt.

In Figur 3 ist ein DRAM-Speicher 10 dargestellt, der ein oder mehrere Speicherzellenfeld(er) 11 mit einer Anzahl von DRAM-Speicherzellen 15 aufweist, wobei einige der Speicherzellen 15 wiederum als dicke schwarze Punkte dargestellt sind und zur besseren Ubersicht nur ein einziges Speicherzellenfeld 11 gezeigt ist. Die Speicherzellen 15 des Speicherzellenfeldes (Cell Array) 11 sind über Bitleitungen 12, beziehungsweise Referenz-Bitleitungen 13, mit einem Schreib-Leseverstärker 30 verbunden.

Der Schreib-Leseverstärker 30 weist erfindungsgemäß ein erstes Schreib-Leseverstärkerelement 40 und ein dazu separates zweites Schreib-Leseverstärkerelement 50 auf. Die einzelnen Verstärkerkomponenten sind auf die beiden Schreib-Leseverstärkerelemente 40, 50 aufgeteilt.

Das erste Schreib-Leseverstärkerelement (SAINT) 40 verfügt über eine N-Latch-Schaltung (NL) 41, eine P-Latch-Schaltung (PL) 42 sowie einen Equalizer (EQ) 43. Die einzelnen Verstärkerkomponenten sind über Auswahltransistoren (MUX1, MUX2)45 mit Bitleitungen (BL) 12 von zu bewertenden Speicherzellen 15 sowie Referenz-Bitleitungen (BBL) 13 von jeweils nicht zu bewertenden Speicherzellen 15 verbunden. Eine Bitleitung 12 sowie eine Referenz-Bitleitung 13 bildet jeweils ein Bitleitungspaar 16, was wiederum durch einen die entsprechenden Bitleitungen umgebenden Kreis symbolisiert ist. Über eine entsprechende Ansteuerung der Auswahltransistoren 45 kann zwischen unterschiedlichen Bitleitungen 12, beziehungsweise Referenz-Bitleitungen 13, hin und her geschaltet werden.

Die einzelnen Bitleitungen 12 sowie Referenz-Bitleitungen 13 sind ebenfalls mit dem zweiten Schreib-Leseverstärkerelement 50 verbunden. Dieses weist eine N-Latch-Schaltung (NLEX) 51 sowie ein Bit-Switch (BS) 54 auf. Die einzelnen Verstärkerkomponenten sind über entsprechende Auswahltransistoren (MUXEX1, MUXEX2) mit den Bitleitungen 12, beziehungsweise Referenz-Bitleitungen 13, verbunden, so daß über eine entsprechende Ansteuerung zwischen einzelnen Bitleitungen 12, beziehungsweise Referenz-Bitleitungen 13 (und damit Bitleitungspaaren 16) hin und her geschaltet werden kann.

Das zweite Schreib-Leseverstärkerelement 50 ist über wenigstens eine externe Datenleitung 31 mit einem zweiten Schreib-Leseverstärker (SSA) 32, bei dem es sich einen externen Schreib-Leseverstärker handelt, verbunden.

Zur Aktivierung der Speicherzellen 15 sind diese mit einer entsprechenden Wortleitung (WL) 14 verbunden.

Nachfolgend wird nun die Funktionsweise eines solchen DRAM-Soeichers 10 beschrieben.

Bei dem in Figur 3 dargestellten Ausführungsbeispiel dient das Schreib-Leseverstärkerelement 40 primär dem Rückschreiben der Zellinformation, während das Schreib-Leseverstärkerelement 50 außerdem die gelesene Information zum weiteren Schreib-Leseverstärker 32 treiben kann und das Schreiben von Zellinformationen ermöglicht.

Zu Beginn des Bewertungsvorgangs wird die Wortleitung 14 aktiviert, wodurch die mit ihr verbundenen Speicherzellen 15 ausgelesen werden können. Die Auswahltransistoren 45, 55 werden zunächst so geschaltet, daß der Auswahltransistor MUX2 angeschaltet und der Auswahitransistor MUXEX2 ausgeschaltet (offen) ist, so daß das mit "2" bezeichnete Bitleitungspaar 16 (die unteren beiden Bitleitungen 12, 13) an das erste Schreib-Leseverstärkerelement 40 angekoppelt ist. Ebenso ist der Auswahltransistor MUX1 ausgeschaltet (offen) und der Auswahltransistor MUXEX1 angeschaltet, so daß das mit "1" bezeichnete obere Bitleitungspaar 16 (die oberen beiden Bitleitungen 12, 13) an das zweite Schreib-Leseverstärkerelement 50 angekoppelt ist.

Die einzelnen Zellsignale werden über die Bitleitungen 12, 13 von dem zweiten Schreib-Leseverstärkerelement 50 über die N-Latch-Schaltung 51 zunächst verstärkt. Wie im Rahmen der allgemeinen Beschreibung eingehend erläutert wurde, bedeutet dies, daß der Spannungspegel derjenigen Bitleitung 12 oder 13 eines Bitleitungspaars, der im Vergleich der beiden Spannungswerte niedriger ist, auf den Low-Pegel herunterverstärkt wird. Dies liegt daran, da alle Bitleitungen 12, 13 vor Beginn des Bewertungsverfahrens mit einer einheitlichen Referenzspannung beaufschlagt wurden.

Die Beaufschlagung mit einem einheitlichen Referenzspannungswert erfolgt über den Equalizer 43.

Wenn die auszulesenden Speicherzellen 15 aktiviert werden, verändert sich durch diese Aktivierung der Spannungswert auf der Bitleitung 12. Bei einer in der Speicherzelle 15 gespeicherten Information logisch "1" geht der Spannungswert beispielsweise leicht rauf, während der Spannungswert bei einer Information logisch "0" beispielsweise leicht runtergeht. Bei der nicht aktivierten Bitleitung, das heißt der Referenz-Bitleitung 13, bleibt der Spannungswert jedoch im wesentlichen unverändert.

Durch die N-Latch-Schaltung 51 wird immer derjenige Spannungswert in einem Bitleitungspaar 16 auf Low-Pegel herunterverstärkt, der den jeweils geringeren Wert aufweist. Wenn der an der Bitleitung 12 anliegende Spannungswert auf Low-Pegel herunterverstärkt wird, bedeutet dies, daß die Information in der zu bewertenden Speicherzelle 15 logisch "0" war. Wenn der Spannungswert an der Referenz-Bitleitung 13 auf Low-Pegel herunterverstärkt wird, bedeutet dies, daß der Informationsgehalt in der zu bewertenden Speicherzelle 15 logisch "1" war.

Gleichzeitig mit dem zweiten Schreib-Leseverstärkerelement 50 werden die Zellsignale auch vom ersten Schreib-Leseverstärkerelement 40 verstärkt. Dabei werden die niedrigeren Spannungen über die N-Latch-Schaltung 41 zum Low-Pegel verstärkt, während die jeweils anderen Zellsignale über die P-Latch-Schaltung 42 auf den vollen High-Pegel verstärkt werden. Wenn beispielsweise das Spannungssignal der zu bewertenden Bitleitung 12 auf Low-Pegel gezogen wurde, wird der Spannungswert der Referenz-Bitleitung 13 auf High-Pegel verstärkt, oder umgekehrt.

Nach dem Zurückschreiben der Informationen durch das erste Schreib-Leseverstärkerelement 40 werden die Bitleitungspaare 16 durch die Auswahltransistoren MUX1 oder MUX2 abgeklemmt, so daß sie mit vollen Spannungspegeln floaten. Die N-Latch-Schaltung 41 des ersten Schreib-Leseverstärkerelements 30 wird dann abgeschaltet, während die noch aktive P-Latch-Schaltung 42 über eine entsprechende Ansteuerung der Auswahltransistoren MUX1 oder MUX2 an das mit dem zweiten Schreib-Leseverstärkerelement 50 verbundene Bitleitungspaar 16 umgeschaltet wird. Die N-Latch-Schaltung 51 des zweiten Schreib-Leseverstärkerelements 50 wird dabei aktiv gehalten. Die bisher nicht verstärkten Spannungen des Bitleitungspaars 16 können auf volle Pegel, das heißt auf High-Pegel, verstärkt und in die Speicherzellen 15 zurückgeschrieben werden.

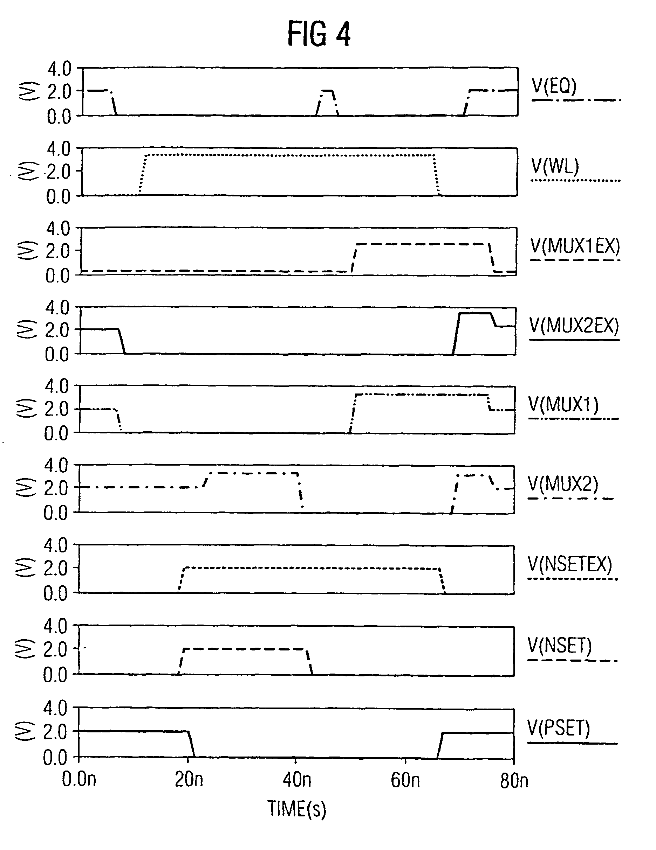

Die notwendige Signalabfolge der Leseverstärkeransteuerung ist in Figur 4 zusammengefaßt. Dabei bedeutet V(EQ) den Spannungsverlauf im Equalizer 43, V(WL) den Spannungsverlauf in der Wortleitung 14, V(MUX1EX) den Spannungsverlauf in einem der Auswahltransistoren 55, V(MUX2EX) den Spannungsverlauf eines anderen Auswahltransistors 55, V(MUX1) den Spannungsverlauf eines Auswahltransistors 45, V(MUX2) den Spannungsverlauf eines anderen Auswahltransistors 45, V(NSETEX) den Spannungsverlauf an der N-Latch-Schaltung 51, V(NSET) den Spannungsverlauf an der N-Latch-Schaltung 41 sowie V (PSET) den Spannungsverlauf an der P-Latch-Schaltung 42.

Durch eine Aktivierung des Bit-Switchs 54 wird auf externen Datenleitungen 31 eine Spannungsdifferenz erzeugt, die dann vom weiteren Schreib-Leseverstärker 32 bewertet und für weitere Prozeßschritte in geeigneter Weise verstärkt werden kann.

Nach Beendigung der Bewertung wird die Wortleitung 14 deaktiviert. Über den Equalizer 43 wird wiederum auf allen Bitleitungen 12 und Referenz-Bitleitungen 13 eine einheitliche Referenzspannung eingestellt.

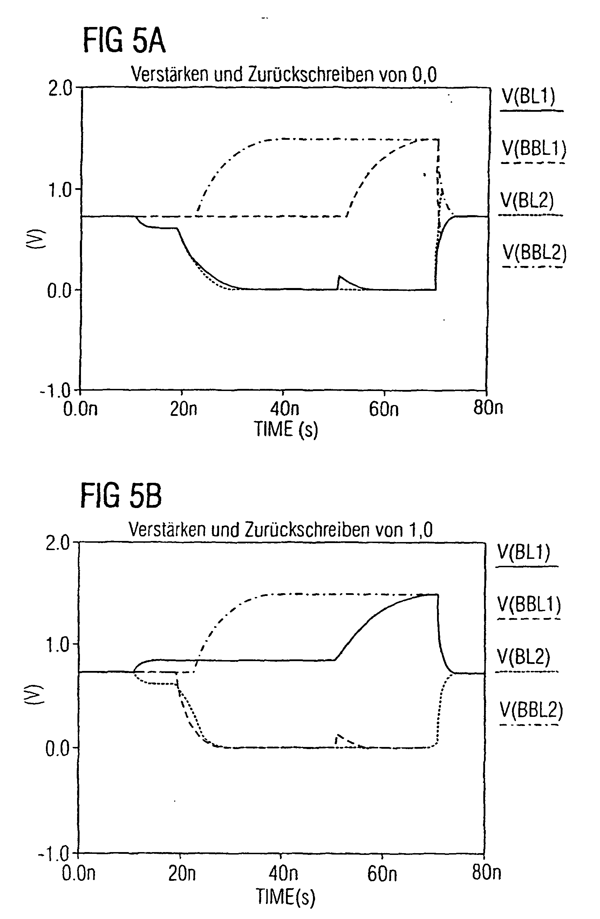

In den Figuren 5a bis 5c sind Spannungsverläufe für das interne Auslesen und Zurückschreiben von Informationen aus/auf in Figur 3 dargestellte(n) Bitleitungspaare(n) 16 dargestellt, wobei die jeweils betrachteten Bitleitungspaare 16 mit einer "1" und einer "2" bezeichnet sind.

In Figur 5a sind die Spannungsverläufe dargestellt, wobei die zu bewertenden Speicherzellen 15 in den entsprechenden Bitleitungspaaren 16 jeweils mit der Information logisch "0" beschrieben sind.

Zu Beginn des Bewertungsverfahrens wird auf allen Bitleitungen 12, 13 ein Referenzspannungswert eingestellt, der im vorliegenden Ausführungsbeispiel 0,75 Volt beträgt. Nun werden die Zellsignale der Zelle 1 und der Zelle 2 durch die N-Latch-Schaltungen 41, 51 des ersten 40 und zweiten 50 Schreib-Leseverstärkerelements verstärkt. Da beide Zellen ursprünglich mit der Information logisch "0" beschrieben waren, verringert sich der Spannungswert bei der Aktivierung im Vergleich zum Referenzspannungswert, was in Figur 5a durch den leichten Abfall bei etwa 10 nsec dargestellt ist. Da beide Spannungswerte an den Bitleitungen 12 der zu bewertenden Speicherzellen etwas geringer als die jeweiligen Referenzspannungswerte sind, werden diese Spannungswerte, die in Figur 5a mit V(BL1) und V(BL2) bezeichnet sind, über die N-Latch-Schaltungen 41, 51 auf Low-Potential gezogen, das im vorliegenden Ausführungsbeispiel 0 Volt beträgt. Da im ersten Schreib-Leseverstärkerelement 40 gleichzeitig auch die P-Latch-Schaltung 42 aktiviert ist, wird in diesem Fall der höhere Spannungswert der Referenz-Bitleitung, der in Figur 5a als V(BBL2) bezeichnet ist, auf den High-Pegel verstärkt, der im Ausführungsbeispiel 1,5 Volt beträgt. Da im zweiten Schreib-Leseverstärkerelement 50 keine P-Latch-Schaltung vorhanden ist, liegt der Referenzspannungswert V(BBL1) zunächst in im wesentlichen unveränderter Form vor.

Nachdem die Informationen der mit dem ersten Schreib-Leseverstärkerelement 40 verbundenen Zellen ausgelesen, bewertet und zurückgeschrieben wurden, werden die Bitleitungen durch die Auswahltransistoren abgeklemmt, so daß sie mit vollen Spannungspegeln floaten. Nun werden die Auswahltransistoren so umgeschaltet, daß die noch aktive P-Latch-Schaltung 42 des ersten Schreib-Leseverstärkerelements 40 an das zweite Schreib-Leseverstärkerelement 50, beziehungsweise an das damit verbundene Bitleitungspaar, angeschaltet wird. Dabei wird die N-Latch-Schaltung 51 im zweiten Schreib-Leseverstärkerelement 50 aktiv gehalten, und die bisher nicht verstärkten Spannungen, das heißt in diesem Fall die Referenz-Bitleitungsspannung V(BBL1) können auf vollen High-Pegel verstärkt und anschließend in die Zelle zurückgeschrieben werden. Im Ausführungsbeispiel gemäß Figur 5a erfolgt dies nach einem Zeitablauf von etwa 50 nsec. Nachdem alle Zellen bewertet wurden, wird die Wortleitung 14 deaktiviert. Uber den Equalizer 43 wird wiederum auf allen Bitleitungen die Referenzspannung von 0,75 Volt eingestellt, was im Ausführungsbeispiel gemäß Figur 5a bei etwa 70 nsec der Fall ist und dadurch kenntlich wird, daß die einzelnen Spannungskurven von den jeweiligen vollen Pegeln auf den Wert der Referenzspannung zusammenlaufen.

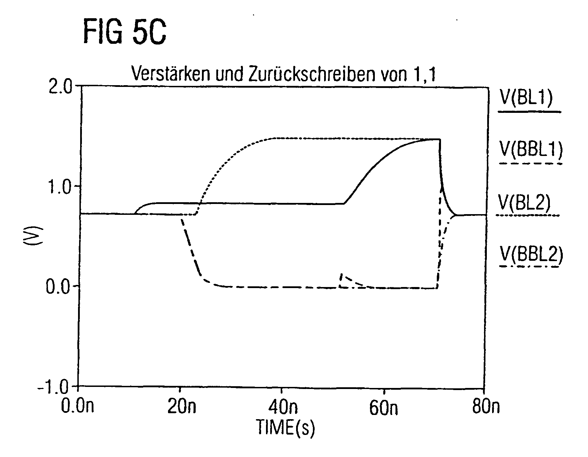

In den Figuren 5b und 5c sind die Spannungsverläufe für jeweils andere Zellinformationskonstellationen dargestellt. In Figur 5b wird eine Situation betrachtet, in der die erste Zelle mit der Information logisch "1" und die zweite Zelle mit der Information logisch "0" beschrieben war. In Figur 5c ist ein Fall dargestellt, in dem die beiden zu bewertenden Zellen jeweils mit der Information logisch "1" beschrieben waren. Der Verlauf der jeweiligen Spannungskurven folgt dabei nach den im Hinblick auf Figur 5a beschriebenen Regeln. Wie aus den Figuren 5b und 5c zu ersehen ist, erhöht sich der Spannungswert der zu bewertenden Bitleitung im Vergleich zur Referenzspannung, wenn die Zelle mit der Information logisch "1" beschrieben ist. Dies wirkt sich dann in entsprechender Weise auf die Verstärkung der Spannungspegel jeweils zum High-Pegel oder zum Low-Pegel aus, wobei die jeweilige Verstärkung nach den unter Figur 5a genannten Maßgaben erfolgt.

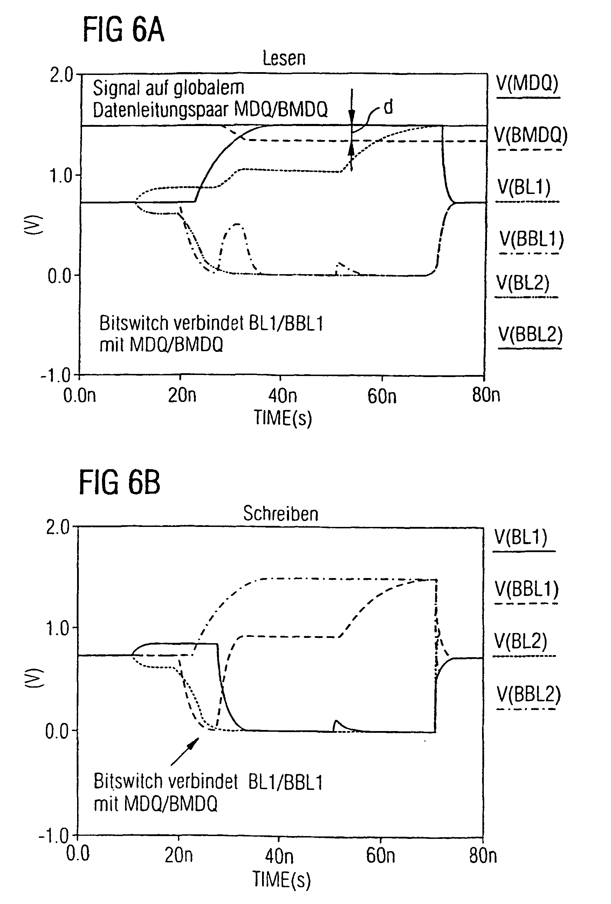

In den Figuren 6a und 6b ist schließlich das externe Lesen (Figur 6a) und das externe Schreiben (Figur 6b) von Zellinformationen einer Speicherzelle an dem in Figur 3 mit "1" bezeichneten Bitleitungspaar 16 dargestellt. Im Fall des Lesens wird durch das Schreib-Leseverstärkerelement 50 nach Aktivierung des Bit-Switchs 54 auf den externen Datenleitungen (MDQ und BMDQ) 31 eine Spannungsdifferenz erzeugt, die durch den in Figur 6a durch Pfeile kenntlich gemachten Abstand d gekennzeichnet ist, und die dann vom externen zweiten Schreib-Leseverstärker 32 bewertet und in geeigneter Weise verstärkt werden kann.

Beim Schreiben gemäß Figur 6b werden über die externen Datenleitungen (MDQ und BMDQ) 31 Spannungspegel an die Latch-Schaltungen der Schreib-Leseverstärkerelemente angelegt, welche diese in die jeweils gewünschte Richtung kippen lassen. In Figur 6b ist dargestellt, wie am Bitleitungspaar 1 (siehe Figur 3) die Zellinformation logisch "0" mit einer Information logisch "1" überschrieben wird.

## Patentansprüche

1. Schreib-Leseverstärker (30) für eine DRAM-Speicherzelle (15), der zum Bewerten des Informationsgehaltes wenigstens einer DRAM-Speicherzelle (15) mit mehreren Bitleitungen (12) und mit mehreren Referenz-Bitleitungen (13), die jeweils ein Bitleitungspaar (16) bilden, verbunden oder verbindbar ist, mit einer Anzahl von Komponenten zum Auswerten, Verstärken und Weiterleiten von aus den Bitleitungen (12) und Referenz-Bitleitungen (13) ausgelesenen Spannungssignalen, wobei der Schreib-Leseverstärker (30) ein erstes Schreib-Leseverstärkerelement (40) und ein dazu separates zweites Schreib-Leseverstärkerelement (50) aufweist und dass die einzelnen Verstärkerkomponenten auf die beiden Schreib-Leseverstärkerelemente (40, 50) aufgeteilt sind, wobei das erste Schreib-Leseverstärkerelement (40) an einem ersten Ende des Bitleitungspaars (16) angeordnet ist und eine erste Latch-Schaltung und eine zweite Latch-Schaltung aufweist und das zweite Schreib-Leseverstärkerelement (50) an einem zweiten Ende des Bitleitungspaars (16) angeordnet ist und eine dritte Latch-Schaltung aufweist, und wobei die Bitleitungen (12) und/oder die Referenz-Bitleitungen (13) mit dem Schreib-Leseverstärker (30) verbunden werden oder verbindbar sind, und wobei die erste Latch-Schaltung zum Verstärken eines Spannungssignals auf einen High-Pegel eingerichtet ist, wobei die zweite Latch-Schaltung zum Verstärken eines Spannungssignals auf einen Low-Pegel eingerichtet ist, und wobei die dritte Latch-Schaltung zum Verstärken eines Spannungssignals auf einen Low-Pegel eingerichtet ist oder zum Verstärken eines Spannungssignals auf einen High-Pegel eingerichtet ist.

2. Schreib-Leseverstärker nach Anspruch 1, **dadurch gekennzeichnet, daß** die Verstärkerkomponenten wenigstens eine N-Latch-Schaltung (41; 51) zum Verstärken eines Spannungssignals auf einen Low-Pegel und/oder wenigstens eine P-Latch-Schaltung (42) zum Verstärken eines Spannungssignals auf einen High-Pegel und/oder wenigstens einen Equalizer (43) zum Herstellen eines Referenzspannungswerts auf der/den Bitleitung(en) (12) sowie der/den Referenz-Bitleitung(en) (13) und/oder wenigstens ein Bit-Switch (54) zum Verbinden wenigstens eines ausgewählten Bitleitungspaares (16) mit wenigstens einer externen Datenleitung (31) aufweisen.

3. Schreib-Leseverstärker nach Anspruch 2, **dadurch gekennzeichnet, daß** im ersten Schreib-Leseverstärkerelement (40) wenigstens eine N-Latch-Schaltung (41) und wenigstens eine P-Latch-Schaltung (42) vorgesehen ist.

4. Schreib-Leseverstärker nach Anspruch 2 oder 3, **dadurch gekennzeichnet, daß** im ersten Schreib-Leseverstärkerelement (40) wenigstens ein Equalizer (43) vorgesehen ist.

5. Schreib-Leseverstärker nach einem der Ansprüche 2 bis 4, **dadurch gekennzeichnet, daß** im zweiten Schreib-Leseverstärkerelement (50) wenigstens eine N-Latch-Schaltung (51) vorgesehen ist.

6. Schreib-Leseverstärker nach einem der Ansprüche 2 bis 5, **dadurch gekennzeichnet, daß** im zweiten Schreib-Leseverstärkerelement (50) wenigstens ein Bit-Switch (54) vorgesehen ist.

7. Schreib-Leseverstärker nach einem der Ansprüche 1 bis 6, **dadurch gekennzeichnet, daß** das zweite Schreib-Leseverstärkerelement (50) mit wenigstens einer externen Datenleitung (31) verbunden oder verbindbar ist.

8. Schreib-Leseverstärker nach einem der Ansprüche 1 bis 7, **dadurch gekennzeichnet, daß** das zweite Schreib-Leseverstärkerelement (50) mit wenigstens einem weiteren Schreib-Leseverstärker (32) verbunden oder verbindbar ist.

9. Schreib-Leseverstärker nach einem der Ansprüche 1 bis 8, **dadurch gekennzeichnet, daß** das erste (40) und/oder zweite (50) Schreib-Leseverstärkerelement einen oder mehrere Transistoren (45; 55) zum Umschalten zwischen verschiedenen Bitleitungen (12), beziehungsweise Referenz-Bitleitungen (13), aufweist/aufweisen.

10. DRAM-Speicher, mit einer Anzahl von DRAM-Speicherzellen (15), die jeweils ein oder mehrere Speicherzellenfelder (11) bilden, wobei jede Speicherzelle (15) mit einer Bitleitung (12; 13) verbunden ist und die Bitleitungen (12; 13) weiterhin mit wenigstens einem Schreib-Leseverstärker (20; 30) verbunden sind, **dadurch gekennzeichnet, daß** der wenigstens eine Schreib-Leseverstärker als Schreib-Leseverstärker (30) nach einem der Ansprüche 1 bis 9 ausgebildet ist.

11. DRAM-Speicher nach Anspruch 10, **dadurch gekennzeichnet, daß** wenigstens eine Wortleitung (14) vorgesehen ist, die über das oder die Speicherzellenfeld(er) (11) hinübergeführt ist und die zum Aktivieren der DRAM-Speicherzellen (15) mit einer oder mehreren Speicherzelle(n) (15) verbunden ist.

12. DRAM-Speicher nach Anspruch 10 oder 11, **dadurch gekennzeichnet, daß** mehrere Bitleitungen (12; 13) eines Speicherzellenfeldes (11) mit einem Schreib-Leseverstärker (30) verbunden sind.

13. DRAM-Speicher nach einem der Ansprüche 10 bis 12, **dadurch gekennzeichnet, daß** jeweils eine Bitleitung (12) einer zu bewertenden DRAM-Speicherzelle (15) und eine Referenz-Bitleitung (13) einer nicht zu bewertenden DRAM-Speicherzelle (15) ein Bitleitungspaar (16) bilden und daß jedes Bitleitungspaar (16) sowohl mit dem ersten (40) als auch mit dem zweiten (50) Schreib-Leseverstärkerelement verbunden ist.

14. DRAM-Speicher nach einem der Ansprüche 10 bis 13, **dadurch gekennzeichnet, daß** die Verbindung einer Bitleitung (12) und/oder Referenz-Bitleitung (13) mit einem Schreib-Leseverstärker (30) über einen oder mehrere Transistoren (45; 55) aktiviert wird oder aktivierbar ist.

15. Verfahren zum Bewerten von DRAM-Speicherzellen eines DRAM-Speichers, insbesondere eines DRAM-Speichers nach einem der Ansprüche 10 bis 14, und insbesondere unter Verwendung eines Schreib-Leseverstärkers nach einem der Ansprüche 1 bis 9, mit folgenden Schritten:
a) Aktivieren einer oder mehrerer zu bewertender Speicherzellen über wenigstens eine Wortleitung;
b) Aktivieren einer Verbindung wenigstens eines aus einer Bitleitung der zu bewertenden Speicherzelle und eines aus einer Referenz-Bitleitung einer nicht zu bewertenden Speicherzelle gebildeten ersten Bitleitungspaares mit einem ersten Schreib-Leseverstärkerelement sowie Aktivieren der Verbindung wenigstens eines zum ersten Bitleitungspaar benachbarten, zweiten Bitleitungspaares mit einem zweiten Schreib-Leseverstärkerelement, wobei beide Bitleitungspaare jeweils mit dem ersten und zweiten Schreib-Leseverstärkerelement verbunden sind;
c) Verstärken der über das erste Bitleitungspaar ausgelesenen Spannungssignale über eine im ersten Schreib-Leseverstärkerelement vorgesehene N-Latch-Schaltung sowie eine P-Latch-Schaltung und Verstärken der über das zweite Bitleitungspaar ausgelesenen Spannungssignale über eine im zweiten Schreib-Leseverstärkerelement vorgesehene N-Latch-Schaltung;
d) Bewerten und Zurückschreiben der Daten der mit dem ersten Schreib-Leseverstärkerelement aktiv verbundenen, zu bewertenden Speicherzelle(n);
e) Umschalten der Verbindung zwischen den Bitleitungspaaren und dem ersten Schreib-Leseverstärkerelement derart, daß die P-Latch-Schaltung des ersten Schreib-Leseverstärkerelements an das zweite Schreib-Leseverstärkerelement umgeschaltet wird;
f) Bewerten und Zurückschreiben der Daten der mit dem zweiten Schreib-Leseverstärkerelement aktiv verbundenen, zu bewertenden Speicherzelle(n); und
g) Deaktivieren der zu bewertenden Speicherzellen.

16. Verfahren nach Anspruch 15, **dadurch gekennzeichnet, daß** vor der Bewertung der Speicherzellen an allen Bitleitungen der in einem oder mehreren Speicherzellenfeld(ern) vorgesehenen Speicherzellen eine einheitliche Referenzspannung angelegt wird.

17. Verfahren nach Anspruch 15 oder 16, **dadurch gekennzeichnet, daß** das mit dem ersten Schreib-Leseverstärkerelement aktiv verbundene Bitleitungspaar nach Beendigung von Schritt d) vom ersten Schreib-Leseverstärkerelement abgeklemmt wird, so daß die Bitleitung und die Referenz-Bitleitung mit vollen Spannungspegeln floaten, und daß anschließend die N-Latch-Schaltung des ersten Schreib-Leseverstärkerelements abgeschaltet wird.

18. Verfahren nach einem der Ansprüche 15 bis 17, **dadurch gekennzeichnet, daß** nach dem Aktivieren eines im zweiten Schreib-Leseverstärkerelement vorgesehenen Bit-Switchs auf einer oder mehreren mit diesem verbundenen externen Datenleitung(en) eine Spannungsdifferenz erzeugt wird.

19. Verfahren nach einem der Ansprüche 15 bis 18, **dadurch gekennzeichnet, daß** nach Beendigung des Bewertungsvorgangs an allen Bitleitungen der bewerteten Speicherzellen über einen Equalizer die einheitliche Referenzspannung angelegt wird.

## Claims

1. A read/write amplifier (30) for a DRAM memory cell (15), which, for evaluation of the information content of at least one DRAM memory cell (15), is connected or can be connected to at least one bit line (12) and to at least one reference bit line (13), which in each case form a bit line pair (16), having a number of components for assessment, amplification and forwarding of voltage signals read from the bit lines (12) and reference bit lines (13), in which case the read/write amplifier (30) has a first read/write amplifier element (40) and a second read/write amplifier element (50) separate therefrom, and in that the individual amplifier components are divided between the two read/write amplifier elements (40, 50), wherein the first read/write amplifier element (40) is arranged at a first end of the bit line pair (16) and comprises a first latch circuit and a second latch circuit and the second read/write amplifier element (50) is arranged at a second end of the bit line pair (16) and comprises a third latch circuit, and wherein the bit lines (12) and/or the reference bit lines (13) are connected or can be connected to the read/write amplifier (30), and wherein the first latch circuit is adapted for amplifying a voltage signal to a high level, wherein the second latch circuit is adapted for amplifying a voltage signal to a low level, and wherein the third latch circuit is adapted for amplifying a voltage signal to a low level or is adapted for amplifying a voltage signal to a high level.

2. The read/write amplifier as claimed in claim 1, **characterized in that** the amplifier components have at least one N latch circuit (41; 51) for amplifying a voltage signal to a low level and/or at least one P latch circuit (42) for amplifying a voltage signal to a high level and/or at least one equalizer (43) for producing a reference voltage value on the bit line(s) (12) and the reference bit line(s) (13) and/or at least one bit switch (54) for connecting at least one selected bit line pair (16) to at least one external data line (31).

3. The read/write amplifier as claimed in claim 2, **characterized in that** at least one N latch circuit (41) and at least one P latch circuit (42) are provided in the first read/write amplifier element (40).

4. The read/write amplifier as claimed in claim 2 or 3,
**characterized in that** at least one equalizer (43) is provided in the first read/write amplifier element (40).

5. The read/write amplifier as claimed in one of claims 2 to 4, **characterized in that** at least one N latch circuit (51) is provided in the second read/write amplifier element (50).

6. The read/write amplifier as claimed in one of claims 2 to 5, **characterized in that** at least one bit switch (54) is provided in the second read/write amplifier element (50).

7. The read/write amplifier as claimed in one of claims 1 to 6, **characterized in that** the second read/write amplifier element (50) is connected or can be connected to at least one external data line (31).

8. The read/write amplifier as claimed in one of claims 1 to 7, **characterized in that** the second read/write amplifier element (50) is connected or can be connected to at least one further read/write amplifier (32).

9. The read/write amplifier as claimed in one of claims 1 to 8, **characterized in that** the first (40) and/or second (50) read/write amplifier element(s) has/have one or more transistors (45; 55) for changing over between different bit lines (12) and reference bit lines (13), respectively.

10. A DRAM memory, having a number of DRAM memory cells (15), which each form one or more memory cell arrays (11), each memory cell (15) being connected to a bit line (12; 13) and the bit lines (12; 13) furthermore being connected to at least one read/write amplifier (20; 30), **characterized in that** the at least one read/write amplifier is designed as a read/write amplifier (30) as claimed in one of claims 1 to 9.

11. The DRAM memory as claimed in claim 10, **characterized in that** at least one word line (14) is provided, which is routed across the memory cell array(s) (11) and, for activation of the DRAM memory cells (15), is connected to one or more memory cell(s) (15).

12. The DRAM memory as claimed in claim 10 or 11, **characterized in that** a plurality of bit lines (12; 13) of a memory cell array (11) are connected to a read/write amplifier (30).

13. The DRAM memory as claimed in one of claims 10 to 12, **characterized in that** in each case a bit line (12) of a DRAM memory cell (15) that is to be evaluated and a reference bit line (13) of a DRAM memory cell (15) that is not to be evaluated form a bit line pair (16), and **in that** each bit line pair (16) is connected both to the first (40) and to the second (50) read/write amplifier element.

14. The DRAM memory as claimed in one of claims 10 to 13, **characterized in that** the connection of a bit line (12) and/or reference bit line (13) to a read/write amplifier (30) is activated or can be activated via one or more transistors (45; 55).

15. A method for evaluating DRAM memory cells of a DRAM memory, in particular of a DRAM memory as claimed in one of claims 10 to 14, and in particular using a read/write amplifier as claimed in one of claims 1 to 9, having the following steps:
a) activation of one or more memory cells that are to be evaluated via at least one word line;
b) activation of a connection of at least one first bit line pair, formed from a bit line of the memory cell that is to be evaluated and a reference bit line of a memory cell that is not to be evaluated, to a first read/write amplifier element, and activation of the connection of at least one second bit line pair, adjacent to the first bit line pair, to a second read/write amplifier element, the two bit line pairs in each case being connected to the first and second read/write amplifier elements;
c) amplification of the voltage signals read out via the first bit line pair by means of one N latch circuit provided in the first read/write amplifier element and also a P latch circuit, and amplification of the voltage signals read out via the second bit line pair by means of one N latch circuit provided in the second read/write amplifier element;
d) evaluation and writing back of the data of the memory cell(s) that is/are to be evaluated and is/are actively connected to the first read/write amplifier element;
e) changeover of the connection between the bit line pairs and the first read/write amplifier element in such a way that the P latch circuit of the first read/write amplifier element is changed over to the second read/write amplifier element;
f) evaluation and writing back of the data of the memory cell(s) that is/are to be evaluated and is/are actively connected to the second read/write amplifier element; and
g) deactivation of the memory cells that are to be evaluated.

16. The method as claimed in claim 15, **characterized in that**, before the evaluation of the memory cells, a uniform reference voltage is applied to all the bit lines of the memory cells provided in one or more memory cell array(s).

17. The method as claimed in claim 15 or 16, **characterized in that** the bit line pair which is actively connected to the first read/write amplifier element is disconnected from the first read/write amplifier element after the end of step d), with the result that the bit line and the reference bit line float with full voltage levels, and **in that** the N latch circuit of the first read/write amplifier element is subsequently switched off.

18. The method as claimed in one of claims 15 to 17, **characterized in that**, after the activation of a bit switch provided in the second read/write amplifier element, a voltage difference is generated on one or more external data line(s) connected to said bit switch.

19. The method as claimed in one of claims 15 to 18, **characterized in that**, after the end of the evaluation operation, the uniform reference voltage is applied to all the bit lines of the evaluated memory cells via an equalizer.

## Revendications

1. Amplificateur d'écriture/lecture (30) pour une cellule de mémoire DRAM (15), qui est ou peut être connecté, pour évaluer le contenu d'informations d'au moins une cellule de mémoire DRAM (15), à plusieurs lignes de bits (12) et à plusieurs lignes de bits de référence (13), qui forment, respectivement, une paire de lignes de bits (16), avec un certain nombre de composants pour l'évaluation, l'amplification et la transmission de signaux de tension extraits des lignes de bits (12) et des lignes de bits de référence (13), dans lequel l'amplificateur d'écriture/lecture (30) présente un premier élément d'amplificateur d'écriture/lecture (40) et un second élément d'amplificateur d'écriture/lecture (50) qui en est séparé et les composants d'amplificateur individuels sont répartis sur les deux éléments d'amplificateur d'écriture/lecture (40, 50), dans lequel le premier élément d'amplificateur d'écriture/lecture (40) est aménagé à une première extrémité de la paire de lignes de bits (16) et présente un premier circuit de bascule et un deuxième circuit de bascule et le second élément d'amplificateur d'écriture/lecture (50) est aménagé à une seconde extrémité de la paire de lignes de bits (16) et présente un troisième circuit de bascule, dans lequel les lignes de bits (12) et/ou les lignes de bits de référence (13) sont ou peuvent être connectées à l'amplificateur d'écriture/lecture (30), dans lequel le premier circuit de bascule est réglé pour amplifier un signal de tension à un haut niveau, dans lequel le deuxième circuit de bascule est réglé pour amplifier un signal de tension à un niveau bas et dans lequel le troisième circuit de bascule est réglé pour amplifier un signal de tension à un niveau bas ou pour amplifier un signal de tension à un haut niveau.

2. Amplificateur d'écriture/lecture selon la revendication 1, **caractérisé en ce que** les composants d'amplificateur présentent au moins un circuit de bascule N (41; 51) pour amplifier un signal de tension à un niveau bas et/ou au moins un circuit de bascule P (42) pour amplifier un signal de tension à un haut niveau et/ou au moins un égaliseur (43) pour établir une valeur de tension de référence sur la ou les lignes de bits (12) ainsi que sur la ou les lignes de bits de référence (13) et/ou au moins un commutateur binaire (54) pour connecter au moins une paire choisie de lignes de bits (16) à au moins une ligne de données externe (31).

3. Amplificateur d'écriture/lecture selon la revendication 2, **caractérisé en ce que**, dans le premier élément d'amplificateur d'écriture/lecture (40), il est prévu au moins un circuit de bascule N (41) et au moins un circuit de bascule P (42).

4. Amplificateur d'écriture/lecture selon la revendication 2 ou 3, **caractérisé en ce qu'**il est prévu au moins un égaliseur (43) dans le premier élément d'amplificateur d'écriture/lecture (40).

5. Amplificateur d'écriture/lecture selon l'une quelconque des revendications 2 à 4, **caractérisé en ce qu'**il est prévu au moins un circuit de bascule N (51) dans le second élément d'amplificateur d'écriture/lecture (50).

6. Amplificateur d'écriture/lecture selon l'une quelconque des revendications 2 à 5, **caractérisé en ce qu'**il est prévu au moins un commutateur binaire (54) dans le second élément d'amplificateur d'écriture/lecture (50).

7. Amplificateur d'écriture/lecture selon l'une quelconque des revendications 1 à 6, **caractérisé en ce que** le second élément d'amplificateur d'écriture/lecture (50) est ou peut être connecté à au moins une ligne de données externe (31).

8. Amplificateur d'écriture/lecture selon l'une quelconque des revendications 1 à 7, **caractérisé en ce que** le second élément d'amplificateur d'écriture/lecture (50) est ou peut être connecté à au moins un autre amplificateur d'écriture/lecture (32).

9. Amplificateur d'écriture/lecture selon l'une quelconque des revendications 1 à 8, **caractérisé en ce que** le premier (40) et/ou le second (50) élément d'amplificateur d'écriture/lecture présente/présentent un ou plusieurs transistors (45; 55) pour commuter entre diverses lignes de bits (12) ou lignes de bits de référence (13).

10. Mémoire DRAM comprenant un certain nombre de cellules de mémoire DRAM (15), qui forment respectivement un ou plusieurs champs de cellules de mémoire (11), dans laquelle chaque cellule de mémoire (15) est connectée à une ligne de bits (12; 13) et les lignes de bits (12; 13) sont en outre connectées à au moins un amplificateur d'écriture/lecture (20; 30), **caractérisée en ce que** le au moins un amplificateur d'écriture/lecture se présente sous la forme d'un amplificateur d'écriture/lecture (30) selon l'une quelconque des revendications 1 à 9.

11. Mémoire DRAM selon la revendication 10, **caractérisée en ce qu'**il est prévu au moins une ligne de mots (14), qui est acheminée via le ou les champs de cellules de mémoire (11) et est connectée à une ou plusieurs cellules de mémoire (15) pour activer les cellules de mémoire DRAM (15).

12. Mémoire DRAM selon la revendication 10 ou 11, **caractérisée en ce que** plusieurs lignes de bits (12; 13) d'un champ de cellules de mémoire (11) sont connectées à un amplificateur d'écriture/lecture (30).

13. Mémoire DRAM selon l'une quelconque des revendications 10 à 12, **caractérisée en ce que**, respectivement, une ligne de bits (12) d'une cellule de mémoire DRAM à évaluer (15) et une ligne de bits de référence (13) d'une cellule de mémoire DRAM (15) qui ne doit pas être évaluée forment une paire de lignes de bits (16) et **en ce que** chaque paire de lignes de bits (16) est connectée autant au premier (40) qu'au second élément (50) de l'amplificateur d'écriture/lecture.

14. Mémoire DRAM selon l'une quelconque des revendications 10 à 13, **caractérisée en ce que** la connexion d'une ligne de bits (12) et/ou d'une ligne de bits de référence (13) est activée ou peut être activée avec un amplificateur d'écriture/lecture (30) via un ou plusieurs transistors (45; 55).

15. Procédé d'évaluation de cellules de mémoire DRAM d'une mémoire DRAM, en particulier d'une mémoire DRAM selon l'une quelconque des revendications 10 à 14 et, en particulier, en utilisant un amplificateur d'écriture/lecture selon l'une quelconque des revendications 1 à 9, selon les étapes suivantes :
a) l'activation d'une ou de plusieurs cellules de mémoire à évaluer via au moins une ligne de mots ;
b) l'activation d'une connexion d'au moins une première paire de lignes de bits formée d'une ligne de bits de la cellule de mémoire à évaluer et d'une ligne de bits de référence d'une cellule mémoire qui n'est pas à évaluer avec un premier élément d'amplificateur d'écriture/lecture, ainsi que l'activation de la connexion d'au moins une seconde paire de lignes de bits adjacente à la première paire de lignes de bit avec un second élément d'amplificateur d'écriture/lecture, les deux paires de lignes de bits étant respectivement connectées au premier et au second élément d'amplificateur d'écriture/lecture ;
c) l'amplification des signaux de tension extraits sur la première paire de lignes de bits via un circuit de bascule N prévu dans le premier élément d'amplificateur d'écriture/lecture ainsi que via un circuit de bascule P et l'amplification des signaux de tension extraits sur la seconde paire de lignes de bits via un circuit de bascule N prévu dans le second élément d'amplificateur d'écriture/lecture ;
d) l'évaluation et la réécriture des données de la ou des cellules de mémoire à évaluer, connectée(s) activement au premier élément d'amplificateur d'écriture/lecture ;
e) le basculement de la connexion entre les paires de lignes de bits et le premier élément d'amplificateur d'écriture/lecture de manière que le circuit de bascule P du premier élément d'amplificateur d'écriture/lecture bascule sur le second élément d'amplificateur d'écriture/lecture ;
f) l'évaluation et la réécriture des données de la ou des cellules de mémoire à évaluer, connectée(s) activement au second élément d'amplificateur d'écriture/lecture ; et
g) la désactivation des cellules de mémoire à évaluer.

16. Procédé selon la revendication 15, **caractérisé en ce qu'**avant l'évaluation des cellules de mémoire, on applique une tension de référence homogène sur toutes les lignes de bits des cellules de mémoire prévues dans un ou plusieurs champs de cellules de mémoire.

17. Procédé selon la revendication 15 ou 16, **caractérisé en ce que** la paire de lignes de bits connectée activement au premier élément d'amplificateur d'écriture/lecture, après l'achèvement de l'étape d), est débranché du premier élément d'amplificateur d'écriture/lecture de sorte que la ligne de bits et la ligne de bits de référence flottent avec des niveaux de tension pleins et **en ce que** le circuit de bascule N du premier élément d'amplificateur d'écriture/lecture est ensuite déconnecté.

18. Procédé selon l'une quelconque des revendications 15 à 17, **caractérisé en ce que**, après l'activation d'un commutateur binaire prévu dans le second élément d'amplificateur d'écriture/lecture, il apparaît une différence de tension sur une ou plusieurs lignes de données externes connectée(s) à celui-ci.

19. Procédé selon l'une quelconque des revendications 15 à 18, **caractérisé en ce que**, après l'achèvement de l'opération d'évaluation, on applique la tension de référence homogène sur toutes les lignes de bits des cellules de mémoire évaluées via un égaliseur.
